# EUROPÄISCHE PATENTANMELDUNG

(11) **EP 0 609 767 A1**
(43) Veröffentlichungstag der Anmeldung: **10.08.1994**
(21) Anmeldenummer: 94101151.2
(22) Anmeldetag: 27.01.1994
(51) Int. Cl.: B21D 11/10, H05K 13/04, H01R 43/16

(54) **Verfahren und Vorrichtung zum Biegen von Werkstücken**

(30) Priorität: 02.02.1993 CH 303/93
(71) Anmelder: SIEMENS-ALBIS AKTIENGESELLSCHAFT, CH-8047 Zürich (CH)
(72) Erfinder: Bachofen, Bruno, CH-8906 Bonstetten (CH)

(57) **Zusammenfassung**

Die Biegevorrichtung weist einen Biegestempel (BST) und einen Formstempel (FST) auf, zwischen denen ein Element (BE) gebogen wird. Der Biegestempel (BST) wird dabei derart auf dem Biegeelement (BE) abgewälzt, dass die von den Stempeln (BST, FST) ausgeübten Kräfte gerade aufeinander und senkrecht zum Biegeelement (BE) stehen. Der Biegeelement (BE) wird dazu in einer kreisförmigen ersten Kurve um das Biegeelement (BE) geführt und in Abhängigkeit von zumindest einer weiteren Kurve (GK) gedreht. Mit dem Biegeverfahren und der entsprechenden Vorrichtung können Biegeelemente (BE) daher nahezu beliebig verformt werden, ohne dass Beschädigungen an deren Oberflächen auftreten. Ferner wird eine wesentliche Verkürzung der Bearbeitungszeit sowie eine Reduktion des Herstellungsaufwandes für die Biegevorrichtung erzielt.

## Beschreibung

Die vorliegende Erfindung betrifft ein Verfahren nach dem Oberbegriff des Patentanspruchs 1 sowie eine Vorrichtung zur Durchführung des Verfahrens nach Anspruch 6 oder 7.

Zum Biegen von Werkstoffen können verschiedene Verfahren angewendet werden. In Dubbel, Taschenbuch für den Maschinenbau, Berlin 1987, Seite S29, Bild 39 werden wichtige Biegeverfahren erläutert, die in Verfahren mit geradliniger Werkzeugbewegung (Bild 39a, freies Biegen; Bild 39b, Gesenkbiegen) und in Verfahren mit drehender Werkzeugbewegung (Bild 39c, Walzrunden; Bild 39d, Schwenkbiegen) unterteilt werden können. Beim freien Biegen wird das Werkstück z.B. einseitig eingespannt und durch einen am freien Ende angreifenden Stempel gebogen. Führt der Stempel dabei eine Schwenkbewegung aus, so handelt es sich um ein Schwenkbiegen. Bei diesem freien Schwenkbiegen liegt der Drehpunkt des Stempels normalerweise im Bereich des eingespannten Werkstückes oder noch weiter zurück. Befestigungsmittel, die den Stempel mit dem Drehpunkt verbinden, verhindern daher die unmittelbare Zufuhr der Werkstücke. Eine derartige Biegevorrichtung ist in Fig. 1 der EP 0 156 068 dargestellt. Gemäss Anspruch 1 der EP 0 156 068 wird dabei ein Arm 14 um einen Mittelpunkt 12 geschwenkt, der in der Mitte der Krümmung einer Teilringfläche 15 vorgesehen ist. Die Anordnung eines Förderbandes im Schwenkbereich des Armes 14 ist daher nicht möglich. Beispielsweise werden die Werkstücke bei bekannten Vorrichtungen daher über ein Förderband zugeführt, durch eine Vorrichtung ergriffen und über einen längeren Weg in die Bearbeitungszone hinein befördert. Dadurch ergibt sich ein beträchtlicher Mehraufwand beim Bau der Biegevorrichtung. Zudem ergibt sich durch diesen Arbeitsschritt (Vor- und Rückbewegung der Werkstücke) eine hohe Bearbeitungszeit für jedes Werkstück bzw. eine tiefe Taktfrequenz.

Nachteilig bei herkömmlichen Vorrichtungen zum freien Schwenkbiegen ist ferner, dass nur eine beschränkte Anzahl von Formen gebogen werden können, die meist starke Abweichungen von den gewünschten (Soll-) Formen aufweisen. Vorzugsweise wird daher ein Formstempel vorgesehen, der an das zu biegende Ende des Werkstückes geführt wird, wonach der Biegestempel das Ende des Werkstückes erfasst und mit einer Schwenk- oder Gleitbewegung gegen den Formstempel anpresst. Durch das Gleiten des Biegestempels relativ zum Formstempel bzw. zum Werkstück können jedoch Schädigungen der Oberfläche des Werkstückes auftreten. Beispielsweise können hochwertige Schutz- oder Kontaktschichten beschädigt oder abgetragen werden.

Der vorliegenden Erfindung liegt daher die Aufgabe zugrunde, ein Verfahren und eine Vorrichtung zu dessen Durchführung zu schaffen, durch die die unmittelbare Zufuhr von Werkstücken sowie das gleitfreie Biegen derselben ermöglicht wird.

Diese Aufgabe wird durch die im kennzeichnenden Teil des Patentanspruchs 1 bzw. 6 oder 7 angegebenen Massnahmen gelöst. Vorteilhafte Ausgestaltungen der Erfindung sind in weiteren Ansprüchen angegeben.

Mit dem erfindungsgemässen Biegeverfahren und der Vorrichtung können Werkstücke nahezu beliebig verformt werden, ohne dass Beschädigungen an den Werkstückoberflächen auftreten. Ferner wird eine wesentliche Verkürzung der Bearbeitungszeit sowie eine Reduktion des Herstellungsaufwandes für die Biegevorrichtung erzielt. Beim Biegen erfolgt dabei eine Abrollbewegung unter praktisch vollständiger Vermeidung von Schleifbewegungen des Werkzeugs auf dem Werkstück.

Die Erfindung wird nachfolgend anhand einer Zeichnung beispielsweise näher erläutert. Dabei zeigt:
- Fig. 1: die erfindungsgemässe Biegevorrichtung
- Fig. 2: ein Formstempelaggregat

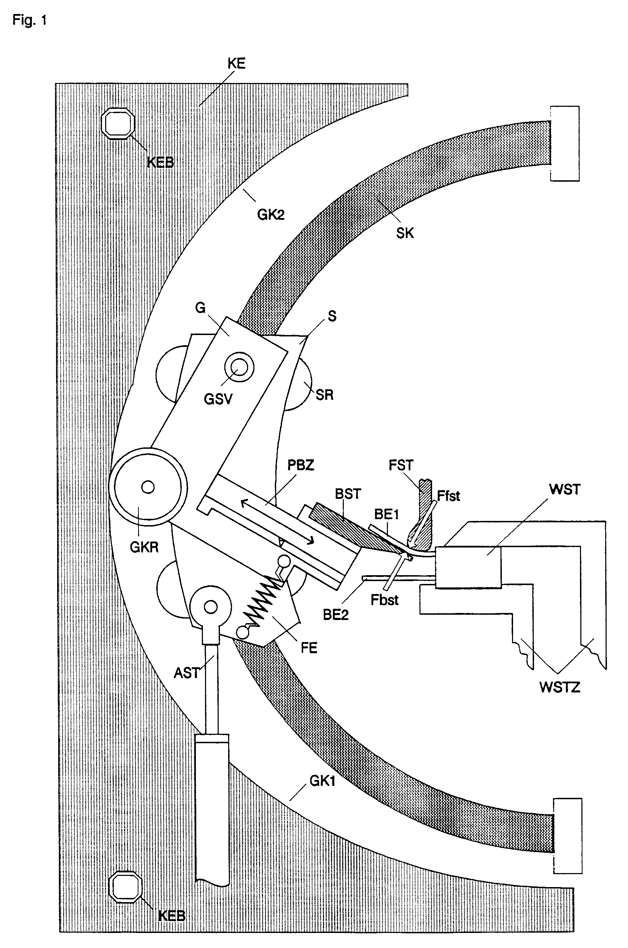

Fig. 1 zeigt einen mit vier Rädern SR versehenen Schlitten S, der entlang einer Schlittenkurve SK geführt ist. Die Räder SR weisen dazu je eine in der Mitte der Lauffläche vorgesehene Nut auf, in die eine an der Aussenfläche der Schlittenkurve SK vorgesehene Rille eingreift. Der beispielsweise von einem Stab AST angetriebene Schlitten S ist über ein Verbirdungselement GSV und eine Feder FE ferner mit einer Gondel G verbunden, die über ein mit der Gondel G verbundenes Rad GKR in einer Kurve GK1 oder GK2 geführt ist. Diese Kurven GK1, GK2 sind in ein Kurvenelement KE eingearbeitet, das jeweils für einen bestimmten Biegevorgang eingesetzt und durch Schrauben KEB feiert wird. Die Gondel G ist mit einem Biegestempel BST versehen, der ein zu biegendes Element BE1 um einen Formstempel FST biegt. Der Biegestempel BST ist auf der Gondel G vorzugsweise verschiebbar angeordnet und wird zu diesem Zweck durch einen pneumatisch oder elektrisch betätigten Zylinder PBZ zwischen zwei oder mehreren Positionen bewegt. Das Biegeelement BE1 ist in einem Werkstück WST eingefügt, das noch eine weiteres in einem nächsten Arbeitsgang zu biegendes Element BE2 enthält und das von einer Zange WSTZ gehalten wird. Das Werkstück WST ist z.B. ein mit n x m Kontakten versehener Steckersockel, der auf einer Schaltplatte zu montieren ist. Mit jedem von m Arbeitsgängen werden daher jeweils n Kontakte derart gebogen, dass alle Kontakte gemeinsam in dafür vorgesehene Öffnungen der Schaltplatte eingsetzt werden können. Aus Dubbel, Taschenbuch für den Maschinenbau, Berlin 1987, Seite S29, Bild 40 geht ferner hervor, dass nach dem Entlasten des gebogenen Elementes eine Rückfederung auftritt. Bei der Wahl des Formstempels FST ist der Rückfederungsfaktor daher zu berücksichtigen. Die Schlittenkurve SK ist vorzugsweise nur etwa halbkreisförmig ausgebildet. Durch die Verwendung der Schlittenkurve SK oder eines nachfolgend beschriebenen mehrgliederigen Gelenkgetriebes erübrigt sich eine ansonsten notwendige Verbindungsstange der Gondel G mit dem Kreismittelpunkt. Aufgrund des Fehlens dieser Verbindungsstange können die Werkstücke z.B. auf einem Förderband durch diesen Kreismittelpunkt bewegt werden, wodurch ein zusätzlicher Transport vom Förderband zum Kreismittelpunkt entfällt.

Die Vorrichtung funktioniert wie folgt. Der Biegestempel BST wird durch den Schlitten S und die Gondel G in die Ausgangslage geführt. Sobald das Werkstück WST durch die Zange WSTZ feiert und nötigenfalls korrekt positioniert ist, fährt der Schlitten S, z.B. durch die Stange AST angetrieben, auf der Schlittenkurve SK nach oben, wodurch das Biegeelement BE1 um den Formstempel FST gebogen wird. Die Gondel G wird durch die Feder FE derart gegen den Schlitten S gezogen, dass das Rad GKR immer der Kurve GK1 oder GK2 folgt. Zu diesem Zweck kann die Gondel G auch in einer geschlossenen Kurve geführt werden. Dadurch könnte auf die Verwendung der Feder FE verzichtet werden. Die Gondel G führt daher bei der Bewegung des Schlittens S entlang der Schlittenkurve SK jeweils eine durch die Kurven GK1, GK2 fest vorgegebene Drehbewegung aus. Die Kurven GK1, GK2 sind dabei derart gewählt, dass die Kräfte Fbst und Ffst, die vom Biegestempel BST und vom Formstempel FST auf das Biegeelement BE1 ausgeübt werden, immer gerade aufeinander und zumindest annähernd senkrecht zum Biegeelement BE stehen. Dadurch entsteht eine Abwälzbewegung des Biegestempels BST auf dem Biegeelement BE1 bzw. auf dem Formstempel FST, durch die das Biegeelement BE1 in die gewünschte Form gebogen wird. Schleif- oder Zugbewegungen, die das Biegeelement BE1 verletzen könnten, werden vermieden. Idealerweise wird das Werkstück ohne weitere Manipulationen direkt auf dem Förderband fixiert. Das Werkstück wird vom Förderband dazu unmittelbar auf der Achse befördert, die durch den Biegemittelpunkt führt. Durch den Wegfall zusätzlicher Manipulationen ergibt sich eine einfachere Vorrichtung sowie eine höhere Taktrate der Biegevorgänge.

Insbesondere falls das Werkstück WST, wie in Fig. 1 gezeigt, mehrere Biegeelemente BE1, BE2 aufweist, ist eine korrekte Positionierung des zu biegenden Elementes BE erforderlich. Dieser Positionierungsvorgang wird vorzugsweise durch die Zange WSTZ vollzogen, die in einer vorzugsweisen Ausgestaltung zum Verschieben (Anheben, Absenken, etc) der Werkstücke WST geeignet ist. Beim Positioniervorgang ist vorzusehen, dass das Werkstück WST oder Teile davon nicht mit dem Biegestempel BST kollidieren. Der Biegestempel BST wird daher durch den Schlitten S und die Gondel G in der Ausgangslage zwischen die für die Biegeelemente BE1 und BE2 vorgesehenen Positionen geführt und soweit zurückgezogen, dass das Werkstück WST von der Zange WSTZ an die vorgesehene Position gebracht werden kann, ohne dass die Biegeelemente BE1, BE2 an den Biegestempel BST anstossen. Anschliessend wird der Formstempel FST von oben und der Biegestempel BST von vorne an das zu biegende Element BE1 bzw. BE2 herangeführt. Danach beginnt der oben beschriebene Biegevorgang.

Der Schlitten S führt den Biegestempel BST um den von der Schlittenkurve SK bestimmten Kreismittelpunkt. Der Biegestempel BST würde daher auf einem punktförmigen Biegeelement ideal abwälzen. Bei der Biegung eines nicht punktförmigen Biegeelementes BE um einen Formstempel FST muss die Lage des Biegestempels BST daher laufend korrigiert werden, damit weiterhin der gewünschte Abwälzvorgang eintritt. Für jedes zu biegende Element BE und den dazugehörigen Formstempel FST ist daher ein bestimmtes Kurvenelement KE vorgesehen. Ferner können pro Kurvenelement KE mehrere Kurven GK1, GK2, ..., GKx vorgesehen werden, wodurch verschiedene Formen des zu biegenden Elementes erzielt werden können.

Aus Dubbel, Taschenbuch für den Maschinenbau, Berlin 1987, Seite l7, Absatz 2.6 und Bild 6 ist ferner bekannt, dass ein Kurvengetriebe in jedem Berührungspunkt durch ein gleichwertiges Gelenkgetriebe ersetzt werden kann (vgl. ferner mit Seite l5, Bild 2a). Die Gondel G könnte daher, anstatt über das Rad mit dem Kurvenelement KE, auch mit einem Gelenkgetriebe verbunden werden, das für die benötigte Auslenkung der Gondel G sorgt. Das Gelenkgetriebe könnte ferner nicht nur für die Auslenkung, sondern auch für den Antrieb der Gondel G und des damit verbundenen Schlittens S sorgen. Der in Fig. 1 gezeigte Antriebsstab AST wäre in diesem Fall Teil des Gelenkgetriebes und könnte z.B. anstelle des Rades GKR mit der Gondel G verbunden werden. Die Feder FE würde in diesem Fall nicht benötigt. Zur Anpassung des Gelenkgetriebes an einen neuen Formstempel FST könnte dabei z.B. ein Glied des mehrgliederigen Gelenkgetriebes mit wenigen Handgriffen ersetzt werden. Ein Gelenkgetriebe ist daher auch anstelle der Schlittenkurve SK und des Schlittens S verwendbar. Z.B. könnte die mit dem Biegestempel BST versehene Gondel G von einem ersten Gelenkgetriebe in einer Bahn geführt werden, die derjenigen der Schlittenkurve SK entspricht. Weiterhin könnte ein Kurvenelement KE oder ein zweites Gelenkgetriebe vorgesehen sein, durch das die Gondelkurven GK festgelegt sind.

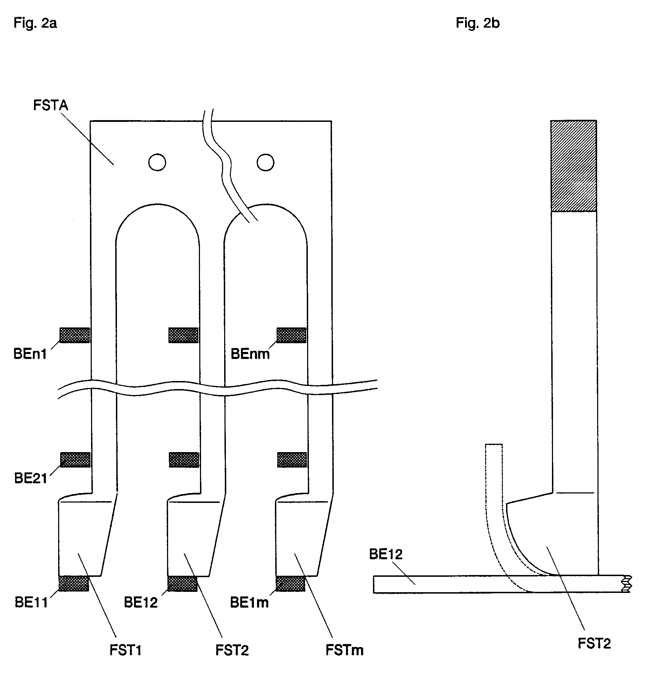

Fig. 2a zeigt ein Formstempelaggregat, das aus m Formstempeln FST1, ...,FSTm besteht. Ferner sind Biegeelemente BE11, ..., BEnm gezeigt, die z.B. als Kontaktelemente in einem Steckverbinder eingefügt sind. Die Formstempel FST sind derart geformt, dass sie von oben zwischen zwei Reihen von Biegeelementen (Formstempel FST1 z.B. zwischen BE11, ..., BEn1 und BE12, ..., BEn2) hindurch und nachfolgend nach links über ein Biegeelement (z.B. Biegeelement BE11) bewegt werden können. In einem ersten Arbeitsschritt wird daher das mit den Biegeelementen BE11, ..., BEmn versehene Werkstück WST über ein Förderband zugeführt und von einer Zange WSTZ erfasst, angehoben und gehalten (s. Fig. 1). Nachfolgend wird das Formstempelaggregat nach unten und seitlich über zu bearbeitende Biegeelemente BE11, ..., BE1m geführt. Anschliessend (oder gleichzeitig) wird der Biegestempel BST nach vorn unter die zu bearbeitende Biegeelemente BE11, ..., BE1m geführt, wonach der eingangs beschrie bene Biegevorgang beginnt. Vorzugsweise werden die verschiedenen Biegeelementlagen (d.h. zuerst die Biegeelemente BEn1, ..., BEnm) sequentiell von oben nach unten abgearbeitet. Für verschiedene Lagen können dabei unterschiedliche Formstempelaggregate FSTA vorgesehen sein. In Fig. 2b ist ein Seitenschnitt des Formstempels FST2 gezeigt, um den das Biegeelement BE12 gebogen wird.

## Patentansprüche

1. Verfahren zum Biegen von mindestens einem Biegeelement (BE) mit einem Biegestempel (BST) und einem Formstempel (FST), **dadurch gekennzeichnet**, dass der Biegestempel (BST) immer derart geführt wird, dass die von den beiden Stempeln (BST, FST) auf das Biegeelement (BE) ausgeübten Kräfte zumindest annähernd gerade aufeinander und senkrecht zu der von den Stempeln (BST, FST) erfassten Stelle des Biegeelementes (BE) stehen.

2. Verfahren nach Anspruch 1, **dadurch gekennzeichnet**, dass der Biegestempel BST um den Biegemittelpunkt und die Biegeelemente (BE) auf einer Achse geführt werden, die derart durch den Biegemittelpunkt führt, dass zumindest grössere Positioniervorgänge entfallen.

3. Verfahren nach Anspruch 1 oder 2, **dadurch gekennzeichnet**, dass der Biegestempel (BST) in Abhängigkeit von zwei Kurven geführt wird.

4. Verfahren nach Anspruch 3, **dadurch gekennzeichnet**, dass die erste Kurve entlang einer Kreisbahn verläuft, die annähernd konzentrisch zur Position des Biegeelementes (BE) vorgesehen ist und dass die zweite Kurve entsprechend der Form des Formstempels (FST) und vorzugsweise unter Berücksichtigung der Dicke des Biegeelementes (BE) gewählt wird.

5. Verfahren nach Anspruch 3 oder 4, **dadurch gekennzeichnet**, dass die Kurven durch ein Kurven- oder ein Gelenkgetriebe realisiert werden.

6. Vorrichtung zur Durchführung des Verfahrens nach Anspruch 1 mit einem Biegestempel (BST), der zum Biegen mindestens eines Biegeelementes (BE) um einen Formstempel (FST) vorgesehen ist, **dadurch gekennzeichnet**, dass der Biegestempel (BST) mit einer Halterung bzw. Gondel (G) verbunden ist, die entlang einer Kurve derart geführt ist, dass der Biegestempel (BST) das innerhalb der Kurve gehaltene Biegeelement (BE) um den Formstempel (FST) biegen kann, dass die Gondel (G) durch einen in einer Schlittenkurve (SK) geführten Schlitten (S) oder durch ein mehrgliederiges Gelenkgetriebe in dieser Kurve geführt ist.

7. Vorrichtung zur Durchführung des Verfahrens nach Anspruch 1 mit einem Biegestempel (BST), der zum Biegen mindestens eines Biegeelementes (BE) um einen Formstempel (FST) vorgesehen ist, **dadurch gekennzeichnet**, dass der Biegestempel (BST) mit einer Halterung bzw. Gondel (G) verbunden ist, die entlang einer ersten Kurve geführt und in Abhängigkeit von einer zweiten Kurve derart drehbar ist, dass der Biegestempel (BST) auf dem Biegeelement (BE) abwälzt, dass die Gondel (G) durch einen in einer Schlittenkurve (SK) geführten Schlitten (S) oder durch ein ein- oder mehrgliederiges Gelenkgetriebe in der ersten Kurve geführt ist.

8. Vorrichtung nach Anspruch 7, **dadurch gekennzeichnet**, dass die erste Kurve zumindest annähernd entlang eines Kreises verläuft und die zweite Kurve zumindest annähernd entsprechend der Form des Formstempels (FST)und der Dicke des Biegeelementes (BE) gewählt ist.

9. Vorrichtung nach Anspruch 6, 7 oder 8, **dadurch gekennzeichnet**, dass der Schlitten (S) Räder (SR) aufweist, die die Schienenkurve (SK) derart umfassen, dass der Schlitten (S) nur entlang der Schlittenkurve (SK) verschiebbar ist, das die Gondel (G) an einer mit dem Schlitten (S) verbundenen Achse (GSV) drehbar gelagert ist und dass die Gondel (G) mit einem Rad (GKR) versehen ist, das in einem mit mindestens einer Kurve (GK) versehenen Kurvenelement (KE) abrollt oder dass die Gondel (G) mit einem Gelenkgetriebe verbunden ist, welches derart ausgestaltet ist, dass die Gondel (G) entsprechend den vorgesehenen Kurven (GK) ausgelenkt wird.

10. Vorrichtung nach Anspruch 9, **dadurch gekennzeichnet**, dass der Schiffen (S) und die Gondel (G) zusätzlich über eine Feder (FE) miteinander verbunden sind.

11. Vorrichtung nach einem der Ansprüche 6 bis 10, **dadurch gekennzeichnet**, dass der Biegestempel (BST) auf der Gondel (G) durch einen pneumatisch oder elektrisch betätigten Zylinder (PBZ) verschiebbar angeordnet ist.

12. Vorrichtung nach einem der Ansprüche 6 bis 11, **dadurch gekennzeichnet**, dass die Gondel (G) oder der Schlitten (S) einer Stange (AST) oder einem Gelenkgetriebe verbunden ist, das für den Antrieb des Schlittens (S) und der Gondel (G) vorgesehen ist.

13. Vorrichtung nach einem der Ansprüche 6 bis 12, **dadurch gekennzeichnet**, dass eine Zange (WSTZ) vorgesehen ist, durch die die mit den Biegeelementen (BE) versehenen Werkstücke (WST), die über ein Förderband zugeführt werden, fixierbar und/oder verschiebbar sind.

14. Vorrichtung nach einem der Ansprüche 6 bis 13, **dadurch gekennzeichnet**, dass der Formstempel (BST) auf ein Biegeelement (BE) absenkbar oder zwischen zwei Reihen von Biegeelementen (BE) absenkbar und/oder seitlich über ein zu biegendes Element (BE) verschiebbar ist.
